# EUROPEAN PATENT SPECIFICATION

(11) **EP 2 065 428 B1**
(45) Date of publication and mention of the grant of the patent: **03.04.2013**
(21) Application number: 07828866.9
(22) Date of filing: 21.09.2007
(51) Int. Cl.: C08G 77/12, C04B 41/81, C09D 183/05, H01L 21/316, H01L 21/76

(54) **METHOD FOR FORMING A SILICONE RESIN**
VERFAHREN ZUR HERSTELLUNG EINES SILIKONHARZES
PROCÉDÉ DE FORMATION D'UNE RÉSINE DE SILICONE

(30) Priority: 21.09.2006 JP 2006256183; 24.11.2006 JP 2006316761; 27.03.2007 JP 2007081917
(43) Date of publication of application: 03.06.2009
(73) Proprietor: JSR Corporation, Tokyo 104-8410 (JP)
(72) Inventor: IWASAWA, Haruo, Chuo-ku, Tokyo 104-0045 (JP); SAKAI, Tatsuya, Chuo-ku, Tokyo 104-0045 (JP); MATSUKI, Yasuo, Chuo-ku, Tokyo 104-0045 (JP); TAMAKI, Kentaro, Chuo-ku, Tokyo 104-0045 (JP)
(74) Representative: TBK
(86) International application number: PCT/JP2007/069125
(87) International publication number: WO 2008/035820

(56) References cited:
- EP-A2- 1 108 763
- WO-A1-98/47942
- WO-A1-2007/018283
- DE-A1- 19 638 998
- JP-A- 03 119 028
- JP-A- 05 255 507
- JP-A- 07 173 434
- JP-A- 11 307 626
- JP-A- 59 084 920
- JP-A- 59 189 126
- JP-A- 59 199 520
- JP-A- 60 042 426
- JP-A- 60 086 018
- JP-A- 2001 308 090
- JP-A- 2003 115 532
- JP-A- 2005 347 636
- JP-A- 2006 310 448
- US-A- 2 547 678

## Description

### TECHNICAL FIELD

The present invention relates to a method of producing a silicone resin.

### BACKGROUND ART

"Trench isolation" is known as a technique for separating from one another the devices of semiconductor equipment formed by integrating a large number of devices at a high density. The trench isolation structure is mainly constructed by forming trenches in a silicon substrate by dry etching, filling the trenches with SiO₂ and planarizing a surface over the trenches by chemical mechanical polishing in the end. This trench isolation has no increase in isolation size caused by a process such as the bird's beak process as compared with an isolation formed by LOCOS (Local Oxidation of Silicon). Therefore, it is suitable for the high integration of devices.

The above trench isolation structure is generally constructed by the method described in "First Semiconductor Process" (written by Kazuo Maeda, Kogyo Chosakai Publishing Co., Ltd., pp. 166-173, 2001). In the commonly used method of forming a trench isolation, for example, a silicon dioxide (SiO₂) film and a silicon nitride (Si₃N₄) film as an oxidation mask are first formed on the top surface of a silicon substrate by chemical vapor deposition (CVD).

Then, an etching mask having a trench pattern is formed from a resist on the top surface of the silicon nitride film by ordinary photolithography, and trenches are formed in the silicon substrate through the silicon nitride film and the silicon oxide film by anisotropic etching such as reactive ion etching. Thereafter, a silicon oxide film is formed on the inner wall of each trench by thermal oxidation or chemical vapor deposition, and then a silicon oxide deposition layer is formed on the inside wall of each trench and the top surface of the silicon nitride film by, for example, chemical vapor deposition. The fillers are planarized by chemical mechanical polishing to form a trench isolation.

However, in the trench isolation formed by the above method, even if an insulator made of silicon dioxide is formed in each trench by chemical vapor deposition having relatively high coverage, when the aspect ratio (trench depth/trench width) of the trench becomes not less than 1, a local void is formed in the inside of the formed silicon dioxide. Therefore, when a heat treatment step is carried out after that, the formed void may expand and destroy the trench isolation.

Then, to form a silicon dioxide deposition layer having few local voids, chemical vapor deposition in which a mixed gas of ozone and tetraethoxysilane (TEOS) is used as a reactive gas is employed. However, even in this method, a local void is formed in the silicon dioxide deposition layer formed in the inside of a trench having an aspect ratio of not less than 2. Since the silicon dioxide deposition layer formed by this chemical vapor deposition process has a lower density than that of a silicon dioxide deposition layer formed by another chemical vapor deposition process, it is difficult to form a silicon dioxide insulator having high resistance.

An expensive vacuum apparatus is required in the above methods, thereby boosting costs. In addition, since the raw material is gaseous, the method has a problem to be solved, such as the contamination of the apparatus and low production yield due to the production of foreign matter.

Recently, a method in which a high-molecular weight liquid dihydrosilicon polymer is used as a coating type silicon dioxide precursor has been proposed (JP-A 2007-45859) . In this technology, a liquid product which is the distillation residue obtained by removing a low-boiling point component from the hydrolytic condensate of H₂SiCl₂ or a high molecular weight liquid product obtained by oxidizing and branching the hydrolytic condensate of H₂SiCl₂ with an inorganic acid is used as a silicon dioxide precursor. JP-A 2007-45859 teaches that, when a super high molecular weight silicon dioxide precursor having a weight average molecular weight of more than 500,000 is used in an Example, a good result is obtained. However, a coating type composition containing the super high molecular weight substance tends to cause coating nonuniformity, and it is difficult to secure uniformity in the thickness of the obtained silicon dioxide film.

DE19638998 discloses solid Si oxide derivatives containing a Si-H bond and of formula HₙSiO_{(4-n)/2} with n being above 0 but less than 2. Further, disclosed is the preparation by hydrolytic condensation at pH 10.5 or lower of 1 mol of an alkoxysilane of formula Hₙ-Si(OR^{o})₄₋ₙ (R^{o} = 1-4 C alkyl) in presence of at least (4-n)/2 mols of water. The derivatives are preferably in the form of spherical primary particles of diameter 0.05-1 micron.

### DISCLOSURE OF THE INVENTION

It is an object of the present invention which has been made in view of the above situation to provide a method of producing a silicone resin

According to the present invention, firstly, the above objects and advantages of the present invention are attained by a method of producing silicone resin which is represented by the following rational formula (1) and is solid at 120°C:

(H₂SiO)ₙ (HSiO_{1.5})ₘ (SiO₂)ₖ (1)

wherein n, m and k are each a number, with the proviso that, when n+m+k=1, n is not less than 0.05, m is more than 0 and not more than 0.95 and k is 0 to 0.2 said method comprises condensing a silicon compound represented by the following formula (2) in an organic solvent under a basic or neutral condition: 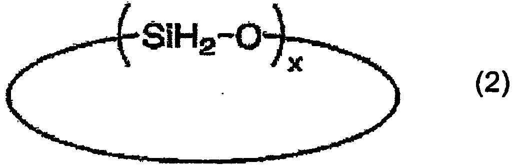 wherein x is an integer of 3 to 25.

Further beneficial embodiments are disclosed in the dependent claims.

Other objects and advantages of the present invention will become apparent from the following description.

### BRIEF DESCRIPTION OF THE DRAWINGS

Fig. 1 is a ¹H-NMR spectral diagram of a silicone resin (cyclic polysiloxane) obtained in Synthesis Example 1;
Fig. 2 is a ²⁹Si-NMR spectral diagram of the same silicone resin as above obtained in Synthesis Example 1;
Fig. 3 is a ¹H-NMR spectral diagram of a silicone resin (polysiloxane after polymerization) obtained in Synthesis Example 2;
Fig. 4 is a ²⁹Si-NMR spectral diagram of the same silicone resin as above obtained in Synthesis Example 2;
Fig. 5 is a ²⁹Si-NMR spectral diagram of a silicone resin obtained in Reference Synthesis Example 11; and
Fig. 6 is a scanning electron micrograph (SEM) photo of the section showing the filling of trenches in Reference Example 10.

### BEST MODE FOR CARRYING OUT THE INVENTION

The present invention will be described in detail hereinunder.

### <silicone resin>

The silicone resin produced by the method of the present invention is represented by the above rational formula (1) . The structure of the silicone resin can be a linear, branched, cyclic or cage structure.

As for the silicone resin produced by the method of the present invention represented by the above rational formula (1), when n+m+k=1, n is not less than 0.05, m is more than 0 and not more than 0.95, and k is 0 to 0.2. n is preferably not less than 0.2, more preferably 0.2 to 0.5. If n is less than 0.05, when the silicone resin produced by the method of the present invention is prepared as a composition comprising dissolved in a solvent, its solubility in a solvent becomes unsatisfactory. Therefore, especially when spin coating is employed, film forming abnormality such as striation is apt to occur. m is more than 0 and not more than 0.95, preferably 0.1 to 0.8, more preferably 0.5 to 0.8. If m is more than 0.95, when the silicone resin produced by the method of the present invention is prepared as a composition dissolved in a solvent, its storage stability degrades and gelation may occur during storage. k is 0 to 0.2, preferably not more than 0.1, particularly preferably 0. If k is more than 0.2, when the silicone resin produced by the method of the present invention is prepared as a composition dissolved in a solvent, its storage stability degrades and gelation may occur during storage.

The molecular weight (weight average molecular weight in terms of polystyrene measured by gel permeation chromatography (GPC), the same shall apply hereinunder) of the silicone resin produced by the method of the present invention is preferably 200 to 500,000, more preferably 1,000 to 100,000, much more preferably 2,000 to 50,000.

The silicone resin produced by the method of the present invention is soluble in a general-purpose organic solvent. Therefore, a composition comprising the silicone resin produced by the method of the present invention and an organic solvent is prepared and can be advantageously used as a coating type silicon dioxide precursor as will be described hereinafter.

The silicone resin produced by the method of the present invention is solid at 120°C. Therefore, when the solvent is removed after the silicone resin produced by the method of the present invention is applied to a substrate as a composition dissolved in a solvent, the coating film after the removal of the solvent becomes stable physically and therefore has a great advantage in terms of handling properties until a heating step or an irradiation step which is carried out subsequently, as compared with conventionally known silicon dioxide precursors (most of them are liquid even after the removal of the solvent).

Further, the silicone resin produced by the method of the present invention has an Si-OH content of preferably not more than 5 %, more preferably not more than 3 % based on the total amount of Si-O bonds. The total amount of Si-O bonds means the total amount of the Si-O bond contained in Si-O-Si and the Si-O bond contained in Si-OH. When the Si-OH bond is existent in the silicone resin in an amount above the range, the storage stability of the silicone resin or the silicone resin composition comprising the silicone resin may be unsatisfactory. Further, it is apprehended that the film may be cracked by compression stress applied to the silicon dioxide film obtained from the silicone resin. However, the silicone resin produced by the method of the present invention does not have the above problems. The Si-OH content can be obtained from the integral value of the ²⁹Si-NMR spectrum of the silicone resin.

### <method of producing silicone resin>

The above silicone resin produced by the method of the present invention is produced by the following method. Method (A): A silicon compound represented by the above formula (2) is condensed in an organic solvent under a basic or neutral condition.

A description is subsequently given of the above method.

### Method (A)

The method of producing the silicone resin of the present invention is to condense a silicon compound represented by the above formula (2) in an organic solvent under a basic or neutral condition.

In the above formula (2), x is 3 to 25, x is preferably 3 to 15, more preferably 3 to 8.

The silicon compound represented by the above formula (2) used in the method (A) can be synthesized by hydrolyzing and condensing dichlorosilane in an organic solvent. A third component such as a catalyst may be added at the time of hydrolysis and condensation besides the organic solvent and water.

The solvent which can be used herein is not particularly limited as long as it does not react with the silicon compound represented by the above formula (2), the silicone resin component and the third component which is optionally added. Examples of the solvent include halogenated hydrocarbon solvents, hydrocarbon solvents, ether solvents and polar solvents. The above halogenated hydrocarbon solvents are preferably chlorinated hydrocarbon solvents such as methylene chloride, chloroform and carbon tetrachloride. The above hydrocarbon solvents include n-pentane, n-hexane, n-heptane, n-octane, decane, dicyclopentane, benzene, toluene, xylene, mesitylene, durene, indene, tetrahydronaphthalene, decahydronaphthalene and squalane. The above ether solvents include diethyl ether, dipropyl ether, dibutyl ether, ethyl butyl ether, ethyl pentyl ether, ethyl hexyl ether, dihexyl ether, dioctyl ether, ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, bis(2-methoxyethyl)ether, p-dioxane and tetrahydrofuran. The above polar solvents include propylene carbonate, γ-butyrolactone, N-methyl-2-pyrrolidone, dimethylformamide and acetonitrile. Out of these, chlorinated hydrocarbon solvents, ether solvents and hydrocarbon solvents are preferred from the viewpoint of the stability of the solution.

The amount of water for hydrolyzing dichlorosilane is preferably not less than 0.5 mole and less than 5 moles, more preferably 0.5 to 3 moles, much more preferably 0.9 to 1.5 moles based on 1 mole of dichlorosilane. When the amount of water is smaller than 0.5 mol%, an unreacted chloro material remains disadvantageously. The amount of water used in this reaction is the total amount of water which is added to a reaction system specifically and all water which may be existent or contained in dichlorosilane, the solvent, the third component, the atmosphere and the used apparatus.

The hydrolysis/condensation reaction of the dichlorosilane is carried out at a temperature of preferably -78 to 100°C, more preferably -20 to 50°C for preferably 0.5 to 3 hours.

Although the silicon compound represented by the above formula (2) is a compound which is stable at room temperature, when it is handled at room temperature, it is preferably handled and stored in the form of a solution dissolved in the above solvent. When it is handled and stored without a solvent, it is desirably carried out at 0°C or lower.

The silicon compound represented by the above formula (2) can be purified by distillation and is desirably subjected to a reaction in the subsequent step after it is purified by distillation. A metal and halogen can be removed by distillation. When the silicon compound represented by the above formula (2) contains impurities such as a metal and halogen, gelation proceeds during storage, and the silicone resin produced by the method of the present invention may not be obtained. When the silicon compound represented by the above formula (2) is purified by distillation, the purified product obtained by distillation is also desirably stored in a solution state. The reduced pressure at the time of distillation is desirably normal pressure (1.013 x 10⁵ Pa) or lower and the heating temperature at the time of distillation is desirably 200°C or lower. The particularly preferred distillation conditions are 5 x 10¹ to 1 x 10⁴ Pa and 30 to 90°C.

The silicone resin produced by the method of the present invention represented by the above rational formula (1) is produced by condensing the silicon compound represented by the above formula (2) in an organic solvent under a basic or neutral condition.

To carry out this condensation reaction under a basic condition, a basic catalyst may be used. The basic catalyst may be an inorganic or organic base. Examples of the inorganic base include lithium hydroxide, sodium hydroxide, potassium hydroxide, calcium hydroxide, barium hydroxide, sodium hydrogen carbonate, potassium hydrogen carbonate, sodium carbonate and potassium carbonate.

Examples of the organic base include linear, branched and cyclic monoalkylamines such as n-hexylamine, n-heptylamine, n-octylamine, n-nonylamine, n-decylamne and cyclohexylamine; linear, branched and cyclic dialkylamines such as di-n-butylamine, di-n-pentylamine, di-n-hexylamine, di-n-heptylamine, di-n-octylamine, di-n-nonylamine, di-n-decylamine, cyclohexylmethylamine and dicyclohexylamine; linear, branched and cyclic trialkylamines such as triethylamine, tri-n-propylamine tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine and tricyclohexylamine; aromatic amines such as aniline, N-methylaniline, N,N-dimethylaniline, 2-methylaniline, 3-methylaniline, 4₋methylaniline, 4-nitroaniline, diphenylamine, triphenylamine and naphthylamine; diamines such as ethylenediamine, N,N,N',N'-tetramethyl ethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene and 1,3-bis[1-(4-aminophenyl)-2-methylethyl]benzene; imidazoles such as imidazole, benzimidazole, 4-methylimidazole and 4-methyl-2-phenylimidazole, pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotin, nicotinic acid, nicotinic acid amide, quinoline, 4-hydroxyquinoline, 8-oxyquinoline and acridine; piperazines such as piperazine and 1-(2-hydroxyethyl)piperazine; and other nitrogen-containing heterocyclic compounds such as pyrazine, pyrazol, pyridazine, quinoxaline, purine, pyrrolidine, piperidine, morpholine, 4-methylmorpholine, 1,4-dimethylpiperazine and 1,4-diazabicyclo[2.2.2]octane.

These basic catalysts may be used alone or in combination of two or more.

The amount of the basic catalyst is preferably not more than 0.01 part by weight based on 100 parts by weight of the silicon compound represented by the above formula (2).

The organic solvent used to condense the silicon compound represented by the above formula (2) is not particularly limited as long as it does not react with the silicon compound represented by the above formula (2), the produced silicone resin component and the optionally used basic catalyst. Examples of the organic solvent include chlorinated hydrocarbon solvents such as methylene chloride, chloroform and carbon tetrachloride; hydrocarbon solvents such as n-pentane, n-hexane, n-heptane, n-octane, decane, dicyclopentane, benzene, toluene, xylene, durene, indene, tetrahydronaphthalene, decahydronaphthalene and squalane; ether solvents such as diethyl ether, dipropyl ether, dibutyl ether, ethyl butyl ether, ethyl pentyl ether, ethyl hexyl ether, ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, bis(2-methoxyethyl)ether, p-dioxane and tetrahydrofuran; and polar solvents such as propylene carbonate, γ-butyrolactone, N-methyl-2-pyrrolidone, dimethylformamide and acetonitrile. Out of these, chlorinated hydrocarbon solvents, ether solvents and hydrocarbon solvents are preferred from the view point of the stability of the solution.

The amount of the solvent is preferably 100 to 10,000 parts by weight based on 100 parts by weight of the silicon compound represented by the above formula (2).

This condensation reaction may be carried out at a temperature ranging from -50 to 200°C, preferably from 0 to 100°C. The condensation reaction time is preferably 0.5 to 3 hours.

In the above method (A), n, m and k can be set to desired values in the above formula (1) by controlling the amount of water. For example, when the amount of water is made small, the value of n can be made large and when the amount of water is made large, the value of m can be made large.

The hydrolysis/condensation reaction for obtaining the silicon compound represented by the above formula (2) from dichlorosilane in the method (A) is a hydrolysis/condensation redaction, a desired reaction can be caused by controlling the amount of water. For example, even when the same dichlorosilane is used as the starting material, if the amount of water is smaller than 5 moles based on 1 mole of dichlorosilane, the silicon compound represented by the above formula (2) can be obtained as a main product and if the amount of water is not smaller than 5 moles, the silicone resin represented by the above rational formula (1) can be obtained as a main product.

### <silicone resin composition>

The silicone resin composition comprises the silicone resin represented by the above rational formula (1) and an organic solvent and optionally other components.

The silicone resin may be contained as one of chemical species which are the same in n, m and k in the above formula (1) and molecular weight or a mixture of two or more different chemical species which differ from each other in at least one of n, m, k and molecular weight.

The above other components include a silicone compound represented by the following formula (4), colloidal silica, metal oxide fine powders and surfactant.

(HS iO _{1.5}) ⱼ (4)

(j is an integer selected from 8, 10, 12, 14 and 16.)

The silicone compound represented by the above formula (4) may be used to control the silicon content of the composition or the viscosity of the composition. When the silicone resin composition contains the silicone compound represented by the above formula (4), the content of the compound is preferably not more than 30 parts by weight, more preferably not more than 20 parts by weight based on 100 parts by weight of the silicone resin.

The above colloidal silica may be used to control the dynamic viscoelasticity of the silicone resin composition. When the silicone resin composition contains the colloidal silica, the content of the colloidal silica is preferably not more than 30 parts by weight, more preferably not more than 20 parts by weight based on 100 parts by weight of the silicone resin. The colloidal silica is preferably added while it is dispersed in an organic solvent which can be used for the silicone resin and will be described hereinafter.

The above metal oxide fine powders may be used to prevent the gelation of the silicone resin composition, increase the viscosity of the silicone resin composition, improve the heat resistance, chemical resistance, hardness and adhesion to the substrate of the obtained silicon dioxide film and prevent static electricity. Examples of the metal oxide which can be used herein include aluminum oxide, zirconium oxide and titanium oxide. The particle diameter of the fine powders is preferably 10 to 50 nm as a number average diameter. When the silicone resin composition comprises the metal oxide fine powders, the content of the metal oxide fine powders is preferably not more than 20 parts by weight, more preferably not more than 10 parts by weight based on 100 parts by weight of the silicone resin.

The above surfactant may be cationic, anionic, amphoteric or nonionic. Out of these, the nonionic surfactant is preferably used because it improves the wettability of a substrate by the silicone resin composition and the leveling properties of the coating film and prevent the generation of irregularities on the coating film and the formation of a citron-like skin. Examples of the nonionic surfactant include fluorine-based surfactants having an alkyl fluoride group or perfluoroalkyl group and polyether alkyl-based surfactants having an oxyalkyl group.

Commercially available products of the above fluorine-based surfactant include F Top EF301, EF303 and EF352 (of Shin Akita Kasei Co. , Ltd.), Megafac F171 and F173 (of Dainippon Ink and Chemicals, Inc.), Asahi Guard AG710 (of Asahi Glass Co., Ltd.), Florade FC-170C, FC430 and FC431 (Sumitomo 3M, Ltd.), Surflon S-382, SC101, SC102, SC103, SC104, SC105 and SC106 (of Asahi Glass Co., Ltd.), BM-1000 and 1100 (of B.M-Chemie), Schsego-Fluor (of Schwegmann GmBH), C₉F₁₉CONHC₁₂H₂₅, C₈F₁₇SO₂NH-(C₂H₄O)₆H, C₉F₁₇O(Pululonic L-35)C₉F₁₇, C₉F₁₇O(Pululonic P-84)C₉F₁₇ and C₉F₁₇O (Tetronic-704) (C₉F₁₇)₂ (Pululonic L-35 : manufactured by Asahi Denka Kogyo K.K., polyoxypropylene-polyoxyethylene block copolymer, average molecular weight of 1,900; Pululonic P-84: manufactured by ADEKA Corporation, polyoxypropylene-polyoxyethylene block copolymer, average molecular weight of 4,200; Tetronic-704: manufactured by ADEKA Corporation, N,N,N',N'-tetrakis(polyoxypropylene-polyoxyethylene block copolymer), average molecular weight of 5,000).

Examples of the above polyether alkyl-based surfactant include polyoxyethylene alkyl ethers, polyoxyethylene allyl ethers, polyoxyethylene alkylphenol ethers, polyoxyethylene fatty acid esters, sorbitan fatty acid esters, polyoxyethylene sorbitan fatty acid esters and oxyethylene oxypropylene block polymer. Commercially available products of the polyether alkyl-based surfactant include Emulgen 105, 430, 810 and 920, Leodol SP-40S and TW-L120, Emanol 3199 and 4110, Excel P-40S, Bridge 30, 52, 72 and 92, Arassel 20, Emasol 320, Tween 20 and 60, and Merge 45 (of Kao Corporation), and Noniball 55 (of Sanyo Chemical Industries, Ltd.):

The other nonionic surfactants include polyoxyethylene fatty acid esters, polyoxyethylene sorbitan fatty acid esters and polyalkylene oxide block copolymers, and commercially available products thereof include Chemistat 2500 (of Sanyo Chemical Industries, Ltd.), SN-EX9228 (of SAN NOPCO Ltd.) and Nonal 530 (of Toho Chemical Industry Co., Ltd.). The amount of the surfactant is preferably not more than 10 parts by weight, particularly preferably 0.1 to 5 parts by weight based on 100 parts by weight of the silicone resin. When the amount of the surfactant is larger than 10 parts by weight, the obtained silicone resin composition tends to foam and may thermally change its color disadvantageously.

The organic solvent used in the silicone resin composition is not particularly limited as long as it can dissolve or disperse the silicone resin represented by the above rational formula (1) and the optionally used other components and does not react with these. The organic solvent is selected from a hydrocarbon solvent, ether solvent and polar solvent. Examples of the hydrocarbon solvent include n-pentane, n-hexane, n-heptane, n-octane, decane, dicyclopentane, benzene, toluene, xylene, durene, indene, tetrahydronaphthalene, decahydronaphthalene and squalane. Examples of the above ether solvent include diethyl ether, dipropyl ether, dibutyl ether, ethyl butyl ether, ethyl pentyl ether, ethyl hexyl ether, dihexyl ether, dioctyl ether, ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, bis(2-methoxyethyl)ether, p-dioxane and tetrahydrofuran. Examples of the above polar solvent include propylene carbonate, γ-butyrolactone, N-methyl-2-pyrrolidone, dimethylformamide and acetonitrile. Out of these, ether solvents and hydrocarbon solvents are preferred from the viewpoint of the stability of the obtained silicone resin composition. These organic solvents may be used alone or in combination of two or more. The amount of the organic solvent which is suitably controlled according to the desired thickness of the silicon dioxide film is preferably not more than 100,000 parts by weight, particularly preferably 400 to 50, 000 parts by weight based on 100 parts by weight of the silicone resin. When the amount of the organic solvent is larger than 100, 000 parts by weight, it may be difficult to form a film from the coating solution. Preferably, the silicone resin composition does not contain water.

The solids content of the silicone resin composition (the ratio of the total weight of components except the solvent of the silicone resin composition to the weight of the composition) is preferably 0.1 to 25 wt%, more preferably 2 to 20 wt%.

The silicone resin composition has a chlorine content of preferably not more than 5 ppm, more preferably not more than 1 ppm. The composition used to form a silicon dioxide film preferably has a low chlorine content from the viewpoint of the insulation properties of the formed silicon oxide film. However, as a raw material compound used to synthesize a silicon dioxide precursor composition has a chlorine atom in many cases, it has been difficult to reduce the chlorine content of the composition. In the present invention, the above chlorine content can be easily achieved by employing the above-described method (A) as the method of synthesizing the silicone resin contained in the composition.

The silicone resin composition can be advantageously used to form a silicon dioxide film and a trench isolation.

### <method of forming a silicon dioxide film>

The method of forming a silicon dioxide film can be carried out by applying the above silicone resin composition to a substrate so as to form a coating film and subjecting the coating film to at least one treatment selected from the group consisting of a heat treatment and an optical treatment to convert the coating film into a silicon dioxide film.

Examples of the above substrate include a silicon substrate, glass substrate, glass-epoxy substrate and synthetic resin substrate. Examples of the material forming the synthetic resin substrate include polyethylene terephthalate, poly(cycloolefin) and hydrogenated products thereof.

The technique of applying the silicone resin composition to the substrate is not particularly limited but spin coating, spray coating, curtain coating, bar coating, printing and ink jet coating may be employed. Spin coating is preferred for semiconductors. Although the coating environment is not particularly limited, coating may be carried out in a suitable environment, for example, an inert atmosphere such as nitrogen, argon or helium; reducing gas atmosphere containing hydrogen; or oxidizing atmosphere such as general air atmosphere.

After coating, the solvent is preferably removed by heating to form a coating film on the substrate. This heat treatment is carried out at preferably 40 to 300°C, more preferably 50 to 200°C for preferably 0.5 to 300 minutes, more preferably 1 to 30 minutes. The thickness of the coating film after the removal of the solvent is preferably 1 to 10, 000 nm, more preferably 5 to 800 nm.

The above heat treatment may be carried out by using general heating means such as hot plate or oven. The heat treatment temperature is preferably 100 to 1,000°C, more preferably 200 to 900°C, much more preferably 300 to 800°C. The heat treatment time is preferably 1 to 300 minutes, more preferably 5 to 120 minutes, much more preferably 10 to 60 minutes. When the treatment temperature is lower than 100°C, the film density becomes low and the reaction for converting the silicone resin film into a silicon dioxide film may become unsatisfactory. When the treatment temperature is higher than 1,000°C, the obtained silicon dioxide film may crack disadvantageously. When the treatment time is shorter than 1 minute, an oxidation reaction may become unsatisfactory and it is not necessary to heat the coating film for a time longer than 300 minutes. The heat treatment is preferably carried out in an inert atmosphere such as nitrogen or an oxidizing atmosphere such as air. A heat treatment at a constant temperature in nitrogen and a heat treatment at a constant temperature in the air may be carried out in combination.

For the above optical treatment, visible radiation, ultraviolet radiation and far ultraviolet radiation may be used, and a low-pressure or high-pressure mercury lamp or deuterium lamp; discharge light of a rare gas such as argon, krypton or xenon; or an excimer laser such as YAG laser, argon laser, carbon dioxide gas laser, XeF, XeCl, XeBr, KrF, KrCl, ArF or ArCl may be used as a light source. Although these light sources having an output of preferably 10 to 5,000 W are used, an output of 100 to 1,000 W suffices. The wavelength of the above radiation is not particularly limited as long as it is absorbed by the silicone resin contained in the composition or the coating film but preferably 170 to 600 nm. The dose of the radiation is preferably 0.1 to 1,000 J/cm², more preferably 1 to 100 J/cm². The preferred atmosphere for the optical treatment differs by the wavelength of the radiation to be applied. In the case of radiation having a wavelength of less than 220 nm, the optical treatment is preferably carried out in an inert atmosphere such as nitrogen and in the case of radiation having a wavelength of not less than 220 nm, the optical treatment is preferably carried out in an oxidizing atmosphere such as air.

The above heat treatment and the optical treatment may be used in combination. In this case, the both treatments may be carried out sequentially or simultaneously. The temperature for carrying out the both treatments simultaneously is preferably room temperature to 500°C, and the treatment time is 0.1 to 60 minutes.

A silicon dioxide film having a thickness of preferably 1 to 9,000 nm, more preferably 3 to 700 nm can be thus formed. The silicon dioxide film formed by the method is superior in film stress to a silicon oxide film formed by a conventionally known method and can be advantageously used for such applications as an interlayer insulating film, hard coating material and glass coating material.

### <method of forming a trench isolation>

The method of forming a trench isolation can be carried out by applying the above silicone resin composition to a silicon substrate having trenches in such a manner that the trenches are filled with the silicone resin composition to form a coating film and subjecting the coating film to at least one treatment selected from the group consisting of a heat treatment and an optical treatment to convert at least the filler in the trenches into silicon dioxide.

To form trenches in the silicon substrate, a known method, for example, a method in which an insulating film consisting of a nitride mask layer and an oxide pad layer is deposited on a substrate and etched in a pattern may be employed. The trench width is preferably 30 to 100,000 nm, more preferably 50 to 50,000 nm. The aspect ratio of the trench (a value obtained by dividing the depth of the trench by the width of the trench) is preferably not more than 50, more preferably not more than 10. In the conventionally known method of forming a trench isolation, when the aspect ratio of the trench is not less than 2, the density of silicon dioxide in the filler of the trench becomes insufficient, whereby the resistivity of the filler may become unsatisfactory or a void may be formed in the filler of the trench, thereby reducing the product yield. However, in the method of forming a trench isolation, even in the case of a substrate having trenches with an aspect ratio of not less than 2, specifically not less than 2.5, particularly not less than 3, no void is formed in the filler and the trenches can be filled with high-density silicon dioxide.

The surface on which the coating film is to be formed of the silicon substrate having trenches may be either planar or nonplanar with level differences and is not limited to a particular form.

The atmosphere for applying the silicone resin composition to the silicon substrate having trenches is the same as in the above-described method of forming a silicon dioxide film. To apply the silicone resin composition to the silicon substrate having trenches, it is applied in such a manner that the trenches are filled with the above silicone resin composition. As the coating technique for realizing this, the above coating techniques used to form a silicon dioxide film may be used. Out of these, spin coating and spray coating are preferred.

After coating, the solvent is removed by preferably heating to form a coating film on the substrate. This heat treatment is carried out at preferably 40 to 300°C, more preferably 50 to 200°C for preferably 0.5 to 300 minutes, more preferably 1 to 30 minutes. The thickness of the coating film after the removal of the solvent (the thickness of a film formed on parts except for the trenches of the substrate) is preferably 5 to 1,000 nm, more preferably 25 to 500 nm.

Then, the coating film formed as described above is subjected to at least one treatment selected from the group consisting of a heat treatment and an optical treatment to convert the filler in the trenches into silicon dioxide. The heat treatment and the optical treatment may be carried out in the same manner as in the method of forming a silicon dioxide film. The treatment time for carrying out the heat treatment and the optical treatment simultaneously for the formation of a trench isolation is about 0.1 to 30 minutes.

To covert the silicone resin into silicon dioxide by optical exposure, a trench isolation can be formed only on a desired part by selectively applying light to part of the coating film by using a photomask having a desired pattern.

The method of forming a trench isolation has an advantage that, even when the aspect ratio of each trench is high regardless of the area and shape of the substrate having trenches, the trenches can be filled with high-density silicon dioxide having no local void. The trench isolation formed by the method is suitable for the manufacture of an electronic device which requires high reliability.

### Examples

The following synthesis examples are provided for the purpose of further illustrating the present invention but are in no way to be taken as limiting.

### I. Synthesis and evaluation of silicone resin by method (A)

### Synthesis Example 1

### <Synthesis Example of silicon compound represented by the above formula (2)>

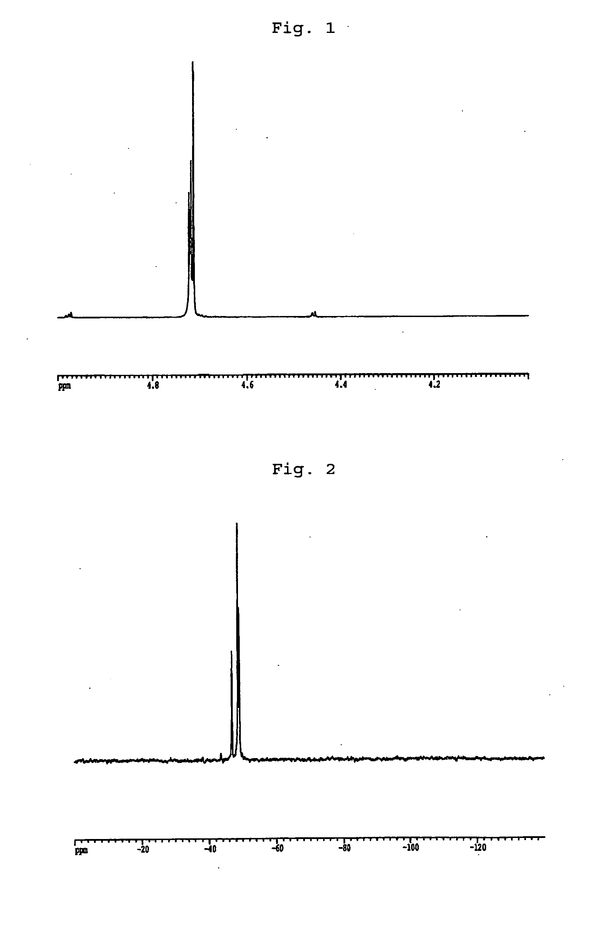

A Dewer condenser, an air introduction tube, a thermometer and a septum were set in a 500 ml four-necked flask, and 200 ml of methylene chloride was fed to the flask in a nitrogen atmosphere. After this reaction system was cooled to -60°C in a dry ice-acetone bath, liquefied H₂SiCl₂ (18.7 g, 185 mmol) was injected into the flask by a syringe, distilled water (3.16 ml, 175 mmol) was added dropwise at the same temperature (-60°C) over 3 minutes, and then the temperature of the reaction system was raised to room temperature over 2 hours. Further, the resulting mixture was stirred at room temperature for 1 hour. Thereafter, the reaction solution was transferred to a separatory funnel, and a methylene chloride layer was washed with 100 ml of distilled water 5 times, dried with magnesium sulfate and filtered to obtain a solution containing a silicon compound (2-1). This solution containing a silicon compound (2-1) was measured by ¹H-NMR and ²⁹Si-NMR. In the ¹H-NMR measurement (Fig. 1), a plurality of peaks derived from Si-H₂ were seen at 4.8 to 4.6 ppm and other peaks excluding a peak derived from the solvent were not seen. In the ²⁹Si-NMR measurement (Fig. 2), peaks derived from the [SiH₂O] structure were seen at -46.9 ppm, -48.6 ppm and -48.9 ppm, and no peak was seen at other locations.

Then, the above solution containing a silicon compound (2-1) was heated to 40°C at normal pressure to distill off methylene chloride so as to concentrate the solution to about 15 ml. Then, this concentrated solution was distilled under a reduced pressure of 66.6 Pa (0.5 mmHg) and heated up to 80°C to obtain 11.4 g of a distillate containing a silicon compound (2-1) . The weight of the distillation residue was 1.7 g. The obtained distillate was measured by ¹H-NMR, ²⁹Si-NMR and GC-MS. In the ¹H-NMR measurement, a peak derived from Si-H₂ was seen at 4.8 to 4.6 ppm, mainly 4.7 to 4.6 ppm. It was found from the integral ratio of a peak derived from Si-H₂ which appeared at 4.8 to 4.6 ppm to a peak derived from methylene chloride that 55 wt% of the silicon compound (2-1) was dissolved in this distillate. In the ²⁹Si-NMR measurement, peaks derived from the [SiH₂O] structure were seen at -46.9 ppm, -48.6 ppm and -48.9 ppm, and no peak was seen at other locations. In the GC-MS analysis, [SiH₂O]₄: m/z 183 (M⁺ -H), [SiH₂O] ₅: m/z 229 (M⁺ -H), [SiH₂O]₆: m/z 275 (M⁺ -H) and [SiH₂O]₇ : m/z 321 (M⁺ -H) were detected.

When the condensation degree of the silicon compound (2-1) was measured by ²⁹Si -NMR, it was found that the silicon compound (2-1) was a mixture of compounds having a condensation degree (x in the above formula (2)) of 4 to 7.

### Synthesis Example 2

### <Synthesis Example of silicone resin represented by the above rational formula (1)>

5 g of the distillate containing a silicon compound (2-1) (containing 55 wt% of the silicon compound (2-1)) obtained in the above Synthesis Example 1 and 5 g of methylene chloride were added to a 50 ml eggplant-shaped flask in the air and stirred at room temperature, and a mixed solution prepared by adding 0.02 g of distilled water to 5.9 ml of a solution containing 0.1 wt% of triethylamine dissolved in methylene chloride was added dropwise to the resulting mixture over 3 minutes and stirred at room temperature for 14 hours. Thereafter, a 1 wt% oxalic acid aqueous solution was added to the reaction solution to terminate the reaction. The reaction solution was transferred to a separatory funnel, 30 ml of n-butyl ether was added to extract, and a 1 wt% oxalic acid aqueous solution was added to the organic layer again to separate the organic layer. Further, the organic layer was washed with distilled water 3 times, the solvent was removed, and solvent substitution work by vacuum distillation was carried out with n-butyl ether 3 times to obtain 27 g of a homogeneous transparent n-butyl ether solution containing a silicone resin (1-1).

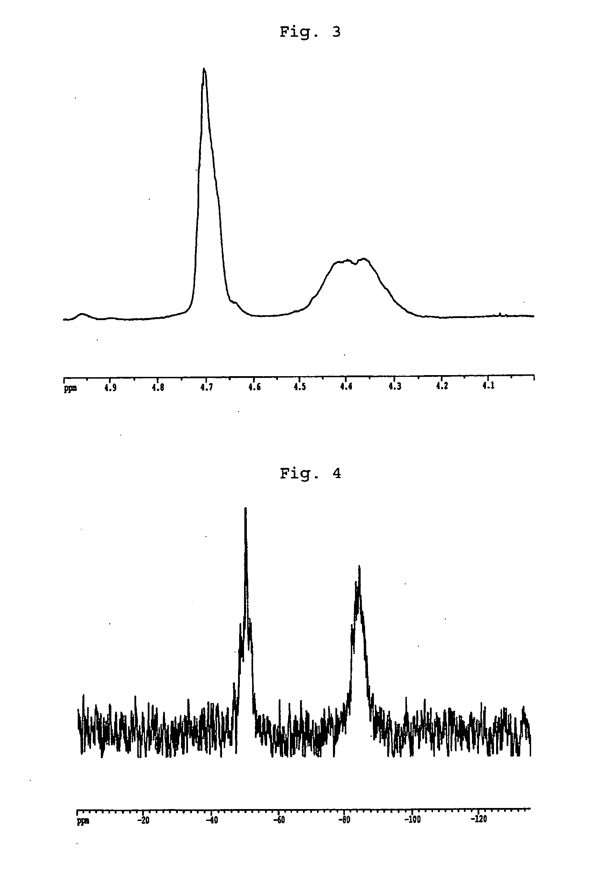

The n-butyl ether solution containing a silicone resin (1-1) was measured by ¹H-NMR and ²⁹Si -NMR. In the ¹H-NMR measurement (Fig. 3), a broad peak derived from Si-H₂ was seen at 4.8 to 4.6 ppm, a broad peak derived from Si-H was seen at 4.5 to 4.3 ppm, and the integral ratio of these was 62:38. Meanwhile, in the ²⁹Si -NMR measurement (Fig. 4), a peak derived from H₂Si (-O)₂ was seen at -47 to -51 ppm, a peak derived from HSi(-O)₃ was seen at -80 to -87 ppm, and the integral ratio of these was 43:57.

When the chlorine content of the n-butyl ether solution containing a silicone resin (1-1) was measured by ion chromatography using a combustion gas absorption method, it was not more than 1 ppm which is the detection limit of the measurement method.

When a small amount of this n-butyl ether solution containing a silicone resin (1-1) was collected and the solvent was distilled off under reduced pressure, a white solid was obtained. This solid was heated at 120°C but did not melt.

The weight average molecular weight in terms of polystyrene measured by GPC of this silicone resin (1-1) was 10,000.

When the n-butyl ether solution containing a silicone resin (1-1) obtained above was left and stored at room temperature (25°C) for 24 hours, no change in its appearance was observed and therefore, storage stability was satisfactory.

### Synthesis Example 3

### <Synthesis Example of silicon compound represented by the above formula (2)>

A Dewer condenser, an air introduction tube, a thermometer and a septum were set in a 500 ml four-necked flask, and 200 ml of toluene was fed to the flask in a nitrogen atmosphere. After this reaction system was cooled to -60°C in a dry ice-acetone bath, liquefied H₂SiCl₂ (24.3 g, 240 mmol) was injected into the flask by a syringe, distilled water (4.10 ml, 228 mmol) was added dropwise at the same temperature (-60°C) over 3 minutes, the temperature of the reaction system was raised to room temperature over 2 hours, and the resulting mixture was stirred at room temperature for 1 hour. Thereafter, the reaction solution was transferred to a separatory funnel, and a toluene layer was washed with 100 ml of distilled water 5 times, dried with magnesium sulfate and filtered to obtain a solution containing a silicon compound (2-2). When the solution containing a silicon compound (2-2) was measured by ¹H-NMR, a plurality of peaks derived from Si-H₂ were seen at 4.8 to 4.6 ppm and other peaks excluding a peak derived from the solvent were not seen.

Then, the above solution containing a silicon compound (2-2) was distilled by heating up to 80°C under a reduced pressure of 2.0 x 10⁴ Pa (150 mm Hg) and further up to 80°C under a reduced pressure of 66.6 Pa (0.5 mmHg) to obtain 198 g of a distillate containing a silicon compound (2-2). The weight of the distillation residue was 3.1 g. When this distillate containing a silicon compound (2-2) was measured by ¹H-NMR, a peak derived from Si-H₂ was seen at 4.8 to 4.7 ppm. It was found from the integral ratio of the peak derived from Si-H₂ which appeared at 4.8 to 4.7 ppm to a peak derived from toluene that 3.0 wt% of the silicon compound (2-2) was dissolved in this distillate.

When the condensation degree of the silicon compound (2-2) was measured by ²⁹Si -NMR, it was found that the silicon compound (2-2) was a mixture of compounds having a condensation degree of 3 to 7.

### Synthesis Example 4

### <Synthesis Example of silicone resin represented by the above rational formula (1) >

50 g of the distillate containing a silicon compound (2-2) (containing 3.0 wt% of the silicon compound (2-2)) obtained in the above Synthesis Example 3 was fed to a 50 ml eggplant-shaped flask in the air, and a mixed solution prepared by adding 0.01 g of distilled water to 0.33 ml of a solution containing 1 wt% of triethylamine dissolved in toluene was added dropwise to the distillate over 3 minutes under agitation at room temperature and further stirred at room temperature for 16 hours.

Thereafter, a 1 wt% oxalic acid aqueous solution was added to the reaction solution to terminate the reaction. The reaction solution was transferred to a separatory funnel, 30 ml of n-butyl ether was added to extract, a 1 wt% oxalic acid aqueous solution was added to the organic layer to separate the organic layer, and the organic layer was washed with distilled water 3 times. Then, the solvent was distilled off, and solvent substitution work by vacuum distillation was carried out with n-butyl ether 3 times to obtain 14.3 g of a homogeneous transparent n-butyl ether solution containing a silicone resin (1-2).

This n-butyl ether solution containing a silicone resin (1-2) was measured by ¹H-NMR and ²⁹Si-NMR. In the ¹H-NMR measurement, a broad peak derived from Si-H₂ was seen at 4.8 to 4.6 ppm, a broad peak derived from Si-H was seen at 4.5 to 4.3 ppm, and the integral ratio of these was 68:32. In the ²⁹Si-NMR measurement, a peak derived from H₂Si(-O)₂ was seen at -47 to -51 ppm, a peak derived from HSi (-O)₃ was seen at -80 to -87 ppm, and the integral ratio of these was 51:49.

When the chlorine content of the n-butyl ether solution containing a silicone resin (1-2) was measured by ion chromatography using a combustion gas absorption method, it was found that the content was not more than 1 ppm which is the detection limit of the measurement method.

When a small amount of this n-butyl ether solution containing a silicone resin (1-2) was collected and the solvent was distilled off under reduced pressure, a white solid was obtained. This solid was heated at 120°C but did not melt.

The weight average molecular weight in terms of polystyrene measured by GPC of this silicone resin (1-2) was 40,000.

The metal content of the n-butyl ether solution containing a silicone resin (1-2) obtained above was measured by ICP-MS. The analytical result is shown in Table 1. The unit of the metal content is ppb and "ND" means that the metal content falls below the measurement limit of the apparatus.

**Table 1**

| Measured element | Li | Na | Mg | Al | K | Ca | Fe | Zn | Cu | Cr | Mn | Ni |
|---|---|---|---|---|---|---|---|---|---|---|---|---|
| Metal content | ND | 2.2 | 1.6 | 0.6 | 0.3 | 1.9 | 0.6 | 0.3 | ND | 0.1 | ND | 0.5 |

When the n-butyl ether solution containing a silicone resin (1-2) obtained above was left and stored at room temperature (25°C) for 24 hours, no change in its appearance was observed and therefore, storage stability was satisfactory.

### Synthesis Example 5

### <Synthesis Example of silicon compound represented by the above formula (2)>

A Dewer condenser, an air introduction tube, a thermometer and a septum were set in a 500 ml four-necked flask, and 200 ml of n-butyl ether was fed to the flask in a nitrogen atmosphere. After this reaction system was cooled to -60°C in a dry ice-acetone bath, liquefied H₂SiCl₂ (24.3 g, 240 mmol) was injected into the flask by a syringe. Distilled water (4.10 ml, 228 mmol) was added dropwise at the same temperature (-60°C) over 3 minutes, and then the resulting mixture was heated up to room temperature over 2 hours and stirred at room temperature for 1 hour. Thereafter, the reaction solution was transferred to a separatory funnel, and an n-butyl ether layer was washed with 100 ml of distilled water 5 times, dried with magnesium sulfate and filtered to obtain a solution containing a silicon compound (2-3) . When this solution containing a silicon compound (2-3) was measured by ¹H-NMR, a plurality of peaks derived from Si-H₂ were seen at 4.8 to 4.6 ppm and other peaks excluding a peak derived from the solvent were not seen.

Then, the above solution containing a silicon compound (2-3) was distilled by heating up to 80°C under a reduced pressure of 2.0 x 10⁴ Pa (150 mmHg) and further up to 80°C under a reduced pressure of 66.6 Pa (0.5 mmHg) to obtain 213 g of a distillate containing a silicon compound (2-3). The weight of the distillation residue was 3.7 g. When this distillate containing a silicon compound (2-3) was measured by ¹H-NMR, a peak derived from Si-H₂ was seen at 4.8 to 4.7 ppm. It was found from the integral ratio of the peak derived from Si-H₂ which appeared at 4.8 to 4.7 ppm to a peak derived from n-butyl ether that 2.7 wt% of the silicon compound (2-3) was dissolved in this distillate.

When the condensation degree of the silicon compound (2-3) was measured by ²⁹Si -NMR, it was found that the silicon compound (2-3) was a mixture of compounds having a condensation degree of 3 to 7.

### Synthesis Example 6

### <Synthesis Example of silicone resin represented by the above rational formula (1) >

55 g of the distillate containing a silicon compound (2-3) (containing 2.7 wt% of the silicon compound (2-3)) obtained in the above Synthesis Example 5 was fed to a 50 ml eggplant-shaped flask in the air, and a mixed solution prepared by adding 0.005 g of distilled water to 0.33 ml of a solution containing 1 wt% of triethylamine dissolved in n-butyl ether was added dropwise to the distillate over 3 minutes under agitation at room temperature and further stirred at room temperature for 16 hours.

Thereafter, a 1 wt% oxalic acid aqueous solution was added to the reaction solution to terminate the reaction. The reaction solution was transferred to a separatory funnel, 30 ml of n-butyl ether was added to extract, a 1 wt% oxalic acid aqueous solution was added to the organic layer to separate the organic layer, the organic layer was washed with distilled water 3 times, and the solvent was distilled off. Then, solvent substitution work by vacuum distillation was carried out with n-butyl ether 3 times to obtain 13.8 g of a homogeneous transparent n-butyl ether solution containing a silicone resin (1-3).

This n-butyl ether solution containing a silicone resin (1-3) was measured by ¹H-NMR and ²⁹Si-NMR. In the ¹H-NMR measurement, a broad peak derived from Si-H₂ was seen at 4.8 to 4.6 ppm, a broad peak derived from Si-H was seen at 4.5 to 4.3 ppm, and the integral ratio of these was 68:32. In the ²⁹Si -NMR measurement, a peak derived from H₂Si(-O)₂ was seen at -47 to -51 ppm, a peak derived from HSi(-O)₃ was seen at -80 to -87 ppm, and the integral ratio of these was 51:49.

When the chlorine content of the n-butyl ether solution containing a silicone resin (1-3) was measured by ion chromatography using a combustion gas absorption method, it was found that the content was not more than 1 ppm which is the detection limit of the measurement method.

When a small amount of this n-butyl ether solution containing a silicone resin (1-3) was collected and the solvent was distilled off under reduced pressure, a white solid was obtained. This solid was heated at 120°C but did not melt.

The weight average molecular weight in terms of polystyrene measured by GPC of this silicone resin (1-3) was 8,000.

When the n-butyl ether solution containing a silicone resin (1-3) obtained above was left and stored at room temperature for 24 hours, no change in its appearance was observed and therefore, storage stability was satisfactory.

### Synthesis Example 7

### <Synthesis Example of silicon compound represented by the above formula (2) >

A dual capacitor, an air introduction tube, a thermometer and a septum were set in a 1-liter four-necked flask, and 400 ml of n-butyl ether was fed to the flask in a nitrogen atmosphere. After this reaction system was cooled to -20°C in a cooling bath, liquefied H₂SiCl₂ (84 g, 820 mmol) was injected into the flask by a syringe. Distilled water (14. 8 ml, 820 mmol) was added dropwise at the same temperature (-20°C) over 60 minutes and then stirred for 1 hour. Thereafter, the reaction solution was transferred to a separatory funnel and washed with 400 ml of distilled water 4 times, and an n-butyl ether layer was dried with magnesium sulfate and filtered to obtain a solution containing a silicon compound (2-4). When this solution containing a silicon compound (2-4) was measured by ¹H-NMR and ²⁹Si-NMR, a plurality of peaks derived from Si-H₂ were seen at 4.8 to 4.6 ppm and other peaks excluding a peak derived from the solvent were not seen in the ¹H-NMR measurement. In the ²⁹Si-NMR measurement, a plurality of peaks derived from [H₂SiO] were seen at -40 to -60 ppm and other peaks were not seen.

Then, the above solution containing a silicon compound (2-4) was distilled by heating up to 50°C under a reduced pressure of 6.66 x 10³ Pa (50 mmHg) to obtain 422 g of a distillate containing a silicon compound (2-4) . The weight of the distillation residue was 15. 0 g. When this distillate containing a silicon compound (2-4) was measured by ¹H-NMR, a peak derived from Si-H₂ was seen at 4.8 to 4.7 ppm. It was found from the integral ratio of the peak derived from Si-H₂ which appeared at 4.8 to 4.7 ppm to a peak derived from n-butyl ether that 4.8 wt% of the silicon compound (2-4) was dissolved in this distillate.

When the condensation degree of the silicon compound (2-4) was measured by ²⁹Si -NMR, it was found that the silicon compound (2-4) was a mixture of compounds having a condensation degree of 3 to 7.

### Synthesis Example 8

### <Synthesis Example of silicone resin represented by the above rational formula (1)>

125 g of the distillate containing a silicon compound (2-4) (containing 4.8 wt% of the silicon compound (2-4)) obtained in the above Synthesis Example 7 was fed to a 300 ml three-necked flask equipped with a thermometer and a dropping funnel in the air, n-butyl ether (33 g) and propylene glycol monoethyl ether acetate (20 g) were mixed with the distillate, and 1.32 ml of a solution containing 0.1 wt% of triethylamine dissolved in n-butyl ether, distilled water (0.70 g, 38 mmol) and propylene glycol monoethyl ether acetate (20 g) were added dropwise over 10 minutes under agitation at 0°C and further stirred for 2 hours.

Thereafter, 1.76 g of an n-butyl ether solution containing 0.1 wt% of oxalic acid was added to the reaction solution to terminate the reaction. The reaction solution was transferred to a separatory funnel and washed with distilled water 4 times, an organic layer was dried with MgSO₄ and separated by filtration, and the solvent was distilled off by an evaporator to obtain 40 g of a homogeneous transparent n-butyl ether solution containing 15 wt% of a silicone resin (1-4).

This n-butyl ether solution containing a silicone resin (1-4) was measured by ¹H-NMR and ²⁹Si-NMR. In the ¹H-NMR measurement, a broad peak derived from Si-H₂ was seen at 4.8 to 4.6 ppm, and a broad peak derived from Si-H was seen at 4.5 to 4.3 ppm. In the ²⁹Si -NMR measurement, a peak derived from H₂Si (-O) ₂ was seen at -47 to -51 ppm, a peak derived from HSi (-O)₃ was seen at -80 to -87 ppm, and the integral ratio of these was 40:60. The content of the Si-OH bond was 2.7 % based on the total weight of Si-O bonds.

When the chlorine content of the n-butyl ether solution containing a silicone resin (1-4) was measured by ion chromatography using a combustion gas absorption method, it was found that the content was not more than 1 ppm which is the detection limit of the measurement method.

When a small amount of this n-butyl ether solution containing a silicone resin (1-4) was collected and the solvent was distilled off under reduced pressure, a white solid was obtained. This solid was heated at 120°C but did not melt.

The weight average molecular weight in terms of polystyrene measured by GPC of this silicone resin (1-4) was 10,000.

When the n-butyl ether solution containing a silicone resin (1-4) obtained above was left and stored at room temperature for 24 hours, no change in its appearance was observed and therefore, storage stability was satisfactory.

### Synthesis Example 9

### <Synthesis Example of silicone resin represented by the above rational formula (1) >

125 g of the distillate containing a silicon compound (2-4) (containing 4.8 wt% of the silicon compound (2-4)) obtained in the above Synthesis Example 7 was fed to a 300 ml three-necked flask equipped with a thermometer and a dropping funnel in the air, n-butyl ether (33 g) and propylene glycol monoethyl ether acetate (20 g) were further added to the flask, and 1.32 ml of a solution containing 0.1 wt% of triethylamine dissolved in n-butyl ether, distilled water (0.82 g, 45 mmol) and propylene glycol monoethyl ether acetate (20 g) were added dropwise over 10 minutes under agitation at 0°C and further stirred for 2 hours.

Thereafter, 1.76 g of an n-butyl ether solution containing 0.1 wt% of oxalic acid was added to the reaction solution to terminate the reaction. The reaction solution was transferred to a separatory funnel and washed with distilled water 4 times, an organic layer was dried with MgSO₄ and filtered, and the solvent was distilled off by an evaporator to obtain 40 g of a homogeneous transparent n-butyl ether solution containing 15 wt% of a silicone resin (1-5).

This n-butyl ether solution containing a silicone resin (1-5) was measured by ¹H-NMR and ²⁹Si-NMR. In the ¹H-NMR measurement, a broad peak derived from Si-H₂ was seen at 4.8 to 4.6 ppm, and a broad peak derived from Si-H was seen at 4.5 to 4.3 ppm. In the ²⁹Si -NMR measurement, a peak derived from H₂Si(-O)₂ was seen at -47 to -51 ppm, a peak derived from HSi(-O)₃ was seen at -80 to -87 ppm, and the integral ratio of these was 30:70. The content of the Si-OH bond was 2.5 % based on the total weight of Si-O bonds.

When the chlorine content of the silicone resin-n-butyl ether solution (M) was measured by ion chromatography using a combustion gas absorption method, it was found that the chlorine content was not more than 1 ppm which is the detection limit of the measurement method.

When a small amount of this n-butyl ether solution containing a silicone resin (1-5) was collected and the solvent was distilled off under reduced pressure, a white solid was obtained. This solid was heated at 120°C but did not melt.

The weight average molecular weight in terms of polystyrene measured by GPC of this silicone resin (1-5) was 30,000.

When the n-butyl ether solution containing a silicone resin (1-5) obtained above was left and stored at room temperature for 24 hours, no change in its appearance was observed and therefore, storage stability was satisfactory.

### Synthesis Example 10

### <Synthesis Example of silicone resin represented by the above rational formula (1)>

125 g of the distillate containing a silicon compound (2-4) (containing 4.8 wt% of the silicon compound (2-4)) obtained in the above Synthesis Example 7 was fed to a 300 ml three-necked flask equipped with a thermometer and a dropping funnel in the air, n-butyl ether (33 g) and propylene glycol monoethyl ether acetate (20 g) were mixed with the distillate, and 1.32 ml of a solution containing 0.1 wt% of triethylamine dissolved in n-butyl ether, distilled water (0.94 g, 52 mmol) and propylene glycol monoethyl ether acetate (20 g) were added dropwise over 10 minutes under agitation at 0°C and further stirred for 2 hours.

Thereafter, 1.76 g of an n-butyl ether solution containing 0.1 wt% of oxalic acid was added to the reaction solution to terminate the reaction. The reaction solution was transferred to a separatory funnel and washed with distilled water 4 times, an organic layer was dried with MgSO₄ and filtered, and the solvent was distilled off by an evaporator to obtain 40 g of a homogeneous transparent n-butyl ether solution containing 15 wt% of a silicone resin (1-6).

This n-butyl ether solution containing a silicone resin (1-6) was measured by ¹H-NMR and ²⁹Si-NMR. In the ¹H-NMR measurement, a broad peak derived from Si-H₂ was seen at 4.8 to 4.6 ppm, and a broad peak derived from Si-H was seen at 4.5 to 4.3 ppm. In the ²⁹Si-NMR measurement, a peak derived from H₂Si (-O)₂ was seen at -47 to -51 ppm, a peak derived from HSi(-O)₃ was seen at -80 to -87 ppm, and the integral ratio of these was 20:80. The content of the Si-OH bond was 2.5 % based on the total weight of Si-O bonds.

When the chlorine content of the silicone resin-n-butyl ether solution (N) was measured by ion chromatography using a combustion gas absorption method, it was found that the chlorine content was not more than 1 ppm which is the detection limit of the measurement method.

When a small amount of this n-butyl ether solution containing a silicone resin (1-6) was collected and the solvent was distilled off under reduced pressure, a white solid was obtained. This solid was heated at 120°C but did not melt.

The weight average molecular weight in terms of polystyrene measured by GPC of this silicone resin (1-6) was 100,000.

When the n-butyl ether solution containing a silicone resin (1-6) obtained above was left and stored at room temperature for 24 hours, no change in its appearance was observed and therefore, storage stability was satisfactory.

### Comparative Example 1

### <Comparative Synthesis Example of silicone resin>

5 g of the distillate containing a silicon compound (2-2) (containing 3.0 wt% of the silicon compound (2-2)) obtained in the above Synthesis Example 3 was fed to a 50 ml eggplant-shaped flask in the air, toluene was distilled off at 80°C under a pressure of 2.0 x 10⁴ Pa (150 mmHg), and the resulting product without the solvent was stirred at 80°C for 4 hours to obtain 15.0 g of a silicone resin (R-1) . This was dissolved in n-butyl ether to prepare an n-butyl ether solution containing 10 wt% of the silicone resin (R-1).

The n-butyl ether solution containing 10 wt% of the silicone resin (R-1) was measured by ¹H-NMR and ²⁹Si-NMR. In the ¹H-NMR measurement, only a broad peak derived from Si-H₂ was seen at 4.8 to 4.6 ppm. In the ²⁹Si-NMR measurement, only a peak which was assumed to be derived from H₂Si (-O) ₂ was seen at -47 to -51 ppm.

When the n-butyl ether solution containing the silicone resin (R-1) obtained above was left and stored at room temperature for 24 hours, no change in its appearance was observed and therefore, storage stability was satisfactory.

### Comparative Synthesis Example 2

### <Comparative Synthesis Example of silicone resin>

350 ml of n-hexane, 40 ml of methanol, 20 ml of concentrated sulfuric acid and 48.6 g (0.3 mol) of anhydrous ferric chloride were fed to a 1,000 ml three-necked flask equipped with a dropping funnel in a nitrogen atmosphere, and a solution prepared by dissolving 25 g (0.185 mol) of trichlorosilane in 200 ml of n-hexane was added dropwise under cooling with ice over 10 hours. After the end of addition, the resulting mixture was further stirred at room temperature for 2 hours, the reaction solution was transferred to a separatory funnel, n-butyl ether was added, an organic layer was washed with 100 ml of distilled water 5 times, dried with calcium chloride and potassium carbonate, filtered and the solvent was distilled off, and further solvent substitution work by vacuum distillation was carried out by using n-butyl ether 3 times to obtain 90 g of a homogeneous transparent n-butyl ether solution containing a silicone resin (R-2).

The solution containing a silicone resin (R-2) was measured by ¹H-NMR and ²⁹Si-NMR. In the ¹H-NMR measurement, only a broad peak derived from Si-H was seen at 4.7 to 4.2 ppm. In the ²⁹Si-NMR measurement, only a plurality of peaks which were assumed to be derived from HSi (-O) ₃ were seen at -80 to -87 ppm.

When the n-butyl ether solution containing a silicone resin (R-2) obtained above was left and stored at room temperature for 24 hours, no change in its appearance was observed and therefore, storage stability was satisfactory.

### <Formation Examples of trench isolation>

### Reference Example 1

The n-butyl ether solution containing a silicone resin (1-1) obtained in the above Synthesis Example 2 as a silicone resin composition was spin coated on a silicon substrate having trenches with a width of 130 nm and an aspect ratio of 3 at a revolution of 2, 000 rpm. The coated substrate was heated on a hot plate set at 150°C for 10 minutes to remove the solvent so as to form a coating film. The coating film was uniform to such an extent that repelling and foreign matter were not observed. The substrate having this coating film was heated on the hot plate at 500°C in the air for 30 minutes to fill a trench pattern with the coating film.

Only silicon and oxygen atoms were detected in the ESCA spectrum of the filler in the trenches of the obtained film, and an organic component such as carbon was not seen at all. Therefore, it was found that this film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by SEM, the trenches were completely filled with the coating film, a local void such as a groove, hole or crack did not exist, and film forming abnormality was not seen.

### Reference Examples 2 to 6

A coating film was formed in the same manner as in Reference Example 1 except that the n-butyl ether solution containing a silicone resin (1-2), (1-3), (1-4), (1-5) or (1-6) obtained in the above Synthesis Example 4, 6, 8, 9 or 10 was used in place of the solution containing a silicone resin (1-1) as a silicone resin composition, and the trench pattern was filled with the coating film by heating in the same manner as in Reference Example 1.

The coating films obtained in the above Reference Examples were uniform without repelling or foreign matter.

In the ESCA spectrum of the filler in the trenches of the films obtained in the above Reference Examples, only silicon and oxygen atoms were detected and an organic component such as carbon was not seen at all. Therefore, it was found that the coating film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by SEM, the trenches were completely filled with the coating film, a local void such as a groove, hole or crack did not exist, and film forming abnormality was not seen.

### Reference Comparative Example 1

An attempt was made to spin coat the silicone resin composition on a substrate having trenches in the same manner as in Reference Example 1 except that the n-butyl ether solution containing a silicone resin (R-1) obtained in the above Comparative Synthesis Example 1 was used in place of the solution containing a silicone resin (1-1) as a silicone resin composition. However, the solution containing a silicone resin (R-1) was repelled on the substrate and a uniform coating film could not be obtained.

### Reference Comparative Example 2

An attempt was made to spin coat the silicone resin composition on a substrate having trenches in the same manner as in Reference Example 1 except that the n-butyl ether solution containing a silicone resin (R-2) obtained in the above Comparative Synthesis Example 2 was used in place of the solution containing a silicone resin (1-1) as a silicone resin composition. However, the coating film formed from the solution containing a silicone resin (R-2) was not uniform due to foreign matter observed in the film.

### Reference Example 7

The procedure of Reference Example 3 (the silicone resin composition used was the solution containing a silicone resin (1-3)) was repeated except that the conditions for heating the coating film were changed to 800°C and 30 minutes to fill the trench pattern with the coating film.

In the ESCA spectrum of the filler in the trenches of the obtained film, only silicon and oxygen atoms were detected, and an organic component such as carbon was not seen. Therefore, it was found that the coating film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by SEM, the trenches were completely filled with the coating film, a local void such as a groove, hole or crack did not exist, and film forming abnormality was not seen.

Further, when the film density of the obtained film was measured by the grazing-incident X-ray analyzer (X' Pert MRD) of Koniklijke Phillips Electronics N.V. in accordance with a Rutherford back scattering method (RBS), it was 2.10 g/cm³. When the silicon substrate having this film formed thereon was immersed in a 0.5 % diluted hydrofluoric acid aqueous solution at room temperature for 1 minute to measure the film etching rate, it was 5.9 nm/min.

### Reference Example 8

The procedure of Reference Example 3 (the silicone resin composition used was the solution containing a silicone resin (1-3)) was repeated except that the conditions for heating the coating film were changed to 1,000°C and 30 minutes to fill the trench pattern with the coating film.

In the ESCA spectrum of the filler in the trenches of the obtained film, only silicon and oxygen atoms were detected, and an organic component such as carbon was not seen at all. Therefore, it was found that the coating film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by SEM, the trenches were completely filled with the coating film, a local void such as a groove, hole or crack did not exist, and film forming abnormality was not seen.

Further, when the film density and etching rate of the obtained film were measured in the same manner as in Reference Example 7, they were 2.20 g/cm³ and 3.2 nm/min, respectively.

### Reference Example 9

A coating film was formed in the same manner as in Reference Example 1 except that the n-butyl ether solution containing a silicone resin (1-3) was used in place of the solution containing a silicone resin (1-1) as a silicone resin composition.

The trench pattern was filled with the coating film by applying ultraviolet radiation having a wavelength of 172 nm at 20 mW/cm² for 30 minutes while the substrate having this coating film was heated on a hot plate at 450°C.

In the ESCA spectrum of the filler in the trenches of the obtained film, only silicon and oxygen atoms were detected, and an organic component such as carbon was not seen at all. Therefore, it was found that the coating film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by SEM, the trenches were completely filled with the coating film, a local void such as a groove, hole or crack did not exist, and film forming abnormality was not seen.

When the film density and etching rate of the obtained film were measured in the same manner as in Reference Example 7, they were 2.23 g/cm³ and 2.5 nm/min, respectively.

### II. Synthesis and evaluation of silicone resin by reference method

### <Synthesis Examples of silicone resin represented by the above rational formula (1)>

### Reference Synthesis Example 11

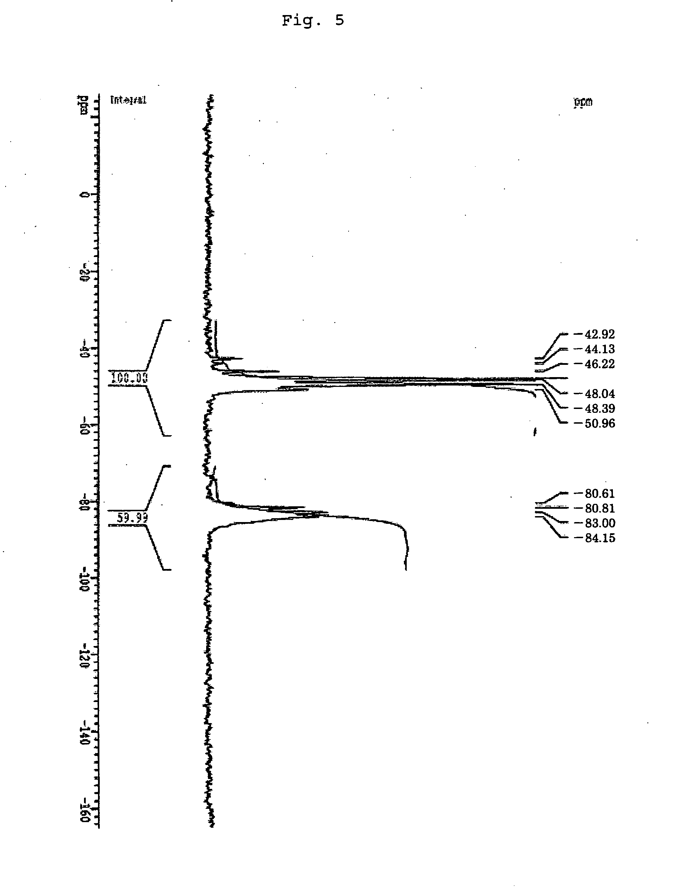

A dual capacitor, an air introduction tube, a thermometer and a septum were set in a 500 ml four-necked flask, and 200 g of dibutyl ether was fed to the flask. After this reaction system was cooled to -60°C with a dry ice-acetone bath, liquefied H₂SiCl₂ (20 g, 0.19 mol) was injected into the flask by a syringe. After the reaction system was heated up to around 0°C, water (43 g, 2.3 mol) was added slowly (during this, the temperature of the reaction system was raised close to room temperature) and stirred at room temperature for 2 hours. Thereafter, an organic layer was washed with 800 g of water and dried with magnesium sulfate, the magnesium sulfate was separated by filtration, and the resulting product was concentrated by an evaporator to obtain a solution containing 15 wt% of a silicone resin (1-7). When this solution was analyzed by ²⁹Si-NMR, a peak derived from H₂Si(-O)₂ was seen at -42 to -50 ppm, a peak derived from HSi(-O)₃ was seen at -80 to -84 ppm, and the area ratio of the H₂Si(-O)₂ peak to the HSi (-O) ₃ peak was 62:38. The ²⁹Si-NMR spectrum is shown in Fig. 5. The content of the Si-OH bond was found to be 2.5 % based on the total amount of Si-O bonds from the integral value of the ²⁹Si -NMR spectrum.

When a small amount of this solution containing a silicone resin (1-7) was collected and the solvent was distilled off under reduced pressure, a white solid was obtained. This solid was heated at 120°C but did not melt.

The weight average molecular weight in terms of polystyrene measured by GPC of this silicone resin (1-7) was 7,000.

### Reference Synthesis Example 12

A solution containing 15 wt% of a silicone resin (1-8) was obtained in the same manner as in Reference Synthesis Example 11 except that H₂Si (OC (O) CH₃)₂ (28 g, 0.19 mol) was used in place of H₂SiCl₂. When the ²⁹Si-NMR spectrum of this solution containing a silicone resin (1-8) was measured, the area ratio of the H₂Si(-O)₂ peak to the HSi(-O)₃ peak was 80:20. The content of the Si-OH bond was found to be 2.7 % based on the total amount of Si-O bonds from the integral value of the ²⁹Si-NMR spectrum.

When a small amount of this solution containing a silicone resin (1-8) was collected and the solvent was distilled off under reduced pressure, a white solid was obtained. This solid was heated at 120°C but did not melt.

The weight average molecular weight in terms of polystyrene measured by GPC of this silicone resin (1-8) was 5,000.

### <Comparative Synthesis Examples of silicone resin>

### Comparative Synthesis Example 3

A solution containing 15 wt% of a silicone resin (R-3) was obtained in the same manner as in Reference Synthesis Example 11 except that H₂Si(OEt)₂ (28 g, 0.19 mol) was used in place of H₂SiCl₂. When the ²⁹Si-NMR spectrum of this solution containing a silicone resin (R-3) was measured, only a peak derived from H₂Si (-O) was seen at -40 to -50 ppm. The Si-OH bond was not observed in the ²⁹Si-NMR spectrum.

### Comparative Synthesis Example 4

A solution containing 15 wt% of a silicone resin (R-4) was obtained in the same manner as in Reference Synthesis Example 11 except that MeHSiCl₂ (22.6 g, 0.19 mol) was used in place of H₂SiCl₂. When the ²⁹Si-NMR spectrum of this solution containing a silicone resin (R-4) was measured, a peak derived from H₂Si (-O) and a peak derived from HSi (-O)₃ were seen and the area ratio of these was 70:30. The content of the Si-OH bond was found to be 2.9 % based on the total amount of Si-O bonds from the integral value of the ²⁹Si-NMR spectrum.

### Comparative Synthesis Example 5

A solution containing 15 wt% of a silicone resin (R-5) was obtained in the same manner as in Reference Synthesis Example 11 except that a mixture of H₂Si(OEt)₂ (22.4 g, 0.15 mol) and HSi(OEt)₃ (6.24 g, 0.038 mol) was used in place of H₂SiCl₂. When the ²⁹Si-NMR spectrum of this solution containing a silicone resin (R-5) was measured, a peak derived from H₂Si(-O)₂ was seen at -42 to -50 ppm, a peak derived from HSi(-O)₃ was seen at -80 to -84 ppm, and the area ratio of the H₂Si(-O)₂ peak to the HSi (-O)₃ peak was 62 : 38 . The content of the Si-OH bond was 12.4 % based on the total amount of Si-O bonds.

### <Examples of formation of trench isolation>

### Reference Example 10

The solution containing a silicone resin (1-7) obtained in the above Reference synthesis Example 11 as a silicone resin composition was spin coated on a silicon substrate having trenches with a width of 130 nm and an aspect ratio of 3 at a revolution of 2,000 rpm. The coated substrate was heated on a hot plate set at 150°C in the air for 10 minutes to remove the solvent so as to form a coating film. The coating film was uniform without repelling and foreign matter. The substrate having this coating film was heated on the hot plate at 500°C in the air for 30 minutes to fill the trench pattern with the coating film.

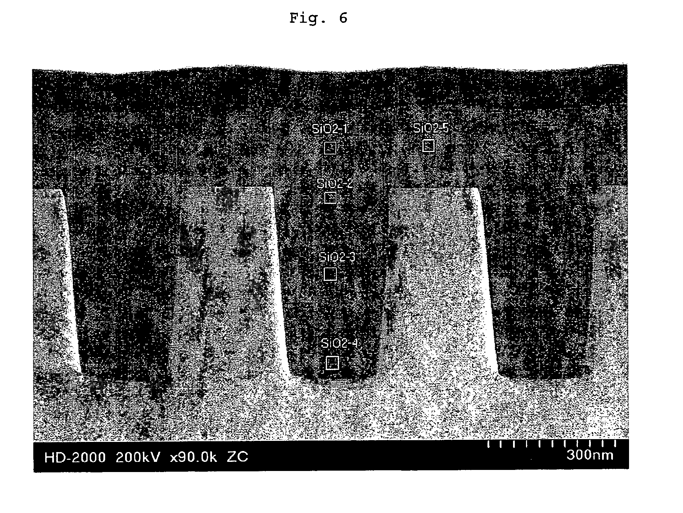

Only silicon and oxygen atoms were detected in the ESCA spectrum of the filler in the trenches of the obtained film, and an organic component such as carbon was not seen at all. Therefore, it was found that this film was a high-purity silicon oxide film. Further, the ratio of the silicon atom to the oxygen atom was found to be 1:2 by SIMS analysis and therefore, it was found that the film was a silicon dioxide film made of SiO₂. When the filled state of each trench was checked by a scanning electron microscope (SEM), the trenches were completely filled with the coating film, a local void such as a groove, hole or crack did not exist, and film forming abnormality was not seen. This SEM image is shown in Fig. 6.

When the internal stress of this silicon dioxide film was measured by the stress meter of KLA-Tencor Corporation, it was a compression stress of 80 MPa.

### Reference Example 11

A trench pattern was filled in the same manner as in Reference Example 10 except that a silicon substrate having trenches with a width of 100 nm and an aspect ratio of 7 was used as a substrate. When the filled state was observed by a scanning electron microscope, a local void such as a groove, hole or crack was not seen and excellent filling properties without film forming abnormality were confirmed.

### Reference Example 12

A trench pattern was filled in the same manner as in Reference Example 10 except that the solution containing a silicone resin (1-8) obtained in the above Reference Synthesis Example 12 was used as a silicone resin composition.

Since only silicon and oxygen atoms were detected in the ESCA spectrum of the filler in the trenches of the obtained film, it was found that the film was a silicon oxide film. Further, since the 2p orbital energy of this silicon was 104 eV, it was found that the film was a silicon dioxide film made of SiO₂. When the filled state of each trench was observed by SEM in the same manner as in Reference Example 10, the trenches were completely filled, a local void such as a groove, hole or crack was not observed, and film forming abnormality was not seen.

### Reference Comparative Example 3

A coating film was formed on a substrate having trenches in the same manner as in Reference Example 10 except that the solution containing a silicone resin (R-3) obtained in the above Comparative Synthesis Example 3 was used as a silicone resin composition. However, in the coating film formed from the solution containing a silicone resin (R-3), repelling was partially observed and a moiré-like film thickness nonuniformity was seen. Thus, the film was inferior in uniformity.

### <Example of formation of silicon dioxide film>

### Reference Example 13

The solution containing a silicone resin (1-7) obtained in the above Reference Synthesis Example 11 as a silicone resin composition was spin coated on a low-resistance silicon substrate having a resistivity of 1 mΩcm at a revolution of 2,000 rpm. The coated substrate was heated on a hot plate set at 150°C in the air for 10 minutes to remove the solvent so as to form a coating film. The coating film was uniform without repelling and foreign matter. The substrate having this coating film formed thereon was heated on the hot plate at 500°C in the air for 30 minutes to form a silicon dioxide film on the substrate.

When aluminum was mask deposited on the obtained silicon dioxide film by vacuum vapor deposition and a current was applied between the low-resistance silicone film and aluminum to evaluate the insulating properties of the silicon dioxide film, the breakdown voltage was 13 MV/cm. Thus, the silicon dioxide film exhibited excellent insulating properties.

### Reference Comparative Example 4

The procedure of Reference Example 13 was repeated to form a film on the substrate except that the solution containing a silicone resin (R-4) obtained in the above Comparative Synthesis Example 4 was used.

When the ESCA analysis of the film was carried out, carbon was detected besides the silicone atom and the oxygen atom. When the internal stress of this film was measured, it was a tensile stress of 30 MPa.

When aluminum was mask deposited on the obtained film by vacuum vapor deposition and a current was applied between the low-resistance silicon film and aluminum to evaluate insulating properties, the breakdown voltage was 8 MV/cm.

### Reference Comparative Example 5

The procedure of Reference Example 13 was repeated to form a film on the substrate except that the solution containing a silicone resin (R-5) obtained in the above Comparative Synthesis Example 5 was used.

When the ESCA analysis of the film was carried out, only silicon and oxygen atoms were detected and an organic component such as carbon was not detected. When the internal stress of this film was measured, it was a compression stress of 30 MPa.

When aluminum was mask deposited on the obtained film by vacuum vapor deposition and a current was applied between the low-resistance silicon film and aluminum to evaluate insulating properties, the breakdown voltage was 8 MV/cm.

## Claims

1. A method of producing a silicone resin, wherein said silicone resin is represented by the following rational formula (1) and is solid at 120°C:
(H₂SiO)ₙ(HSiO_{1.5})ₘ (SiO₂)ₖ (1)
wherein n, m and k are each a number, with the proviso that, when n+m+k=1, n is not less than 0.05, m is more than 0 and not more than 0.95 and k is 0 to 0.2, said method comprises condensing a silicon compound represented by the following formula (2) in an organic solvent under a basic or neutral condition: 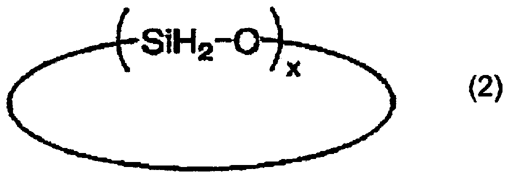 wherein x is an integer of 3 to 25.

2. The method according to claim 1, wherein k = 0 in the above formula (1).

3. The method according to claim 1 or 2, wherein the content of a Si-OH bond obtained from the integral value of a ²⁹Si-NMR spectrum measured for the above silicone resin is not more than 5 % based on the total amount of Si-O bonds.

## Patentansprüche

1. Verfahren zur Herstellung eines Silikonharzes, wobei das Silikonharz durch die folgende rationale Formel (1) dargestellt ist und bei 120°C fest ist:
(H₂SiO)ₙ (HSiO_{1,5})ₘ (SiO₂)ₖ (1)
wobei n, m und k jeweils eine Zahl sind, unter der Voraussetzung, dass, wenn n+m+k=1, n nicht weniger als 0,05 ist, m mehr als 0 und nicht mehr als 0,95 ist und k 0 bis 0,2 ist, wobei das Verfahren Kondensieren einer Silikonverbindung, die durch die folgende Formel (2) dargestellt ist, in einem organischen Lösungsmittel unter basischen oder neutralen Bedingungen, umfasst: 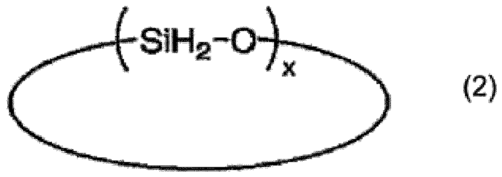 wobei x eine ganze Zahl von 3 bis 25 ist.

2. Verfahren nach Anspruch 1, wobei in der obigen Formel (1) k = 0 ist.

3. Verfahren nach Anspruch 1 oder 2, wobei der Gehalt an einer Si-OH Bindung, der erhalten wird von dem Integralwert eines ²⁹Si-NMR-Spektrums, das für das obige Silikonharz gemessen wird, basierend auf der gesamten Menge an Si-O-Bindungen nicht mehr als 5 % ist.

## Revendications

1. Procédé de production d'une résine de silicone, dans lequel ladite résine de silicone est représentée par la formule rationnelle (1) suivante et est solide à 120°C :
(H₂SiO)ₙ(HSiO_{1,5})ₘ(SiO₂)ₖ (1)
dans laquelle n, m et k sont chacun un nombre, sous réserve que, lorsque n+m+k=1, n n'est pas inférieur à 0,05, m est supérieur à 0 et non supérieur à 0,95 et k est 0 à 0,2, ledit procédé comprend la condensation d'un composé de silicium représenté par la formule (2) suivante dans un solvant organique sous une condition basic ou neutre : 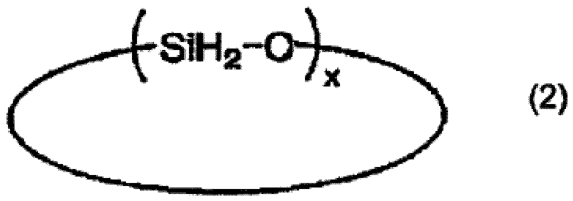 dans laquelle x est un entier de 3 à 25.

2. Procédé selon la revendication 1, dans lequel k = 0 dans la formule (1) ci-dessus.

3. Procédé selon la revendication 1 ou 2, dans lequel la teneur d'une liaison Si-OH obtenue à partir de la valeur entière d'un spectre de RMN du ²⁹Si mesurée pour la résine de silicone ci-dessus n'est pas supérieure à 5% sur la base de la quantité totale de liaisons Si-0.
